# FASCICULE DE BREVET EUROPEEN

(11) **EP 1 797 441 B1**
(45) Date de publication et mention de la délivrance du brevet: **22.03.2017**
(21) Numéro de dépôt: 05807542.5
(22) Date de dépôt: 30.09.2005
(51) Int. Cl.: G01R 31/311

(54) **PROCEDE ET INSTALLATION D'ANALYSE D'UN CIRCUIT INTEGRE**
VERFAHREN UND INSTALLATION ZUR ANALYSE EINER INTEGRIERTEN SCHALTUNG
METHOD AND INSTALLATION FOR ANALYZING AN INTEGRATED CIRCUIT

(30) Priorité: 01.10.2004 FR 0410424
(43) Date de publication de la demande: 20.06.2007
(73) Titulaire: CENTRE NATIONAL D'ETUDES SPATIALES, 75001 Paris (FR)
(72) Inventeur: DESPLATS, Romain, F-31320 CASTANET-TOLOSAN (FR); SANCHEZ, Kévin, F-31400 TOULOUSE (FR); BEAUDOIN, Félix, 95051 SANTA CLARA CA (US)
(74) Mandataire: Lavoix
(86) Numéro de dépôt international: PCT/FR2005/002422
(87) Numéro de publication internationale: WO 2006/037881

(56) Documents cités:
- WO-A-2004/092754
- WO-A-2005/008850
- US-B1- 6 501 288

## Description

La présente invention concerne un procédé d'analyse d'un circuit intégré.

Les circuits intégrés fonctionnent à grande vitesse et la moindre faiblesse interne risque de mettre leur fonctionnement global en défaillance. Dans le cas de circuits utilisés dans des environnements particulièrement contraints, tels que rencontrés lors de missions spatiales, l'environnement radiatif ou les contraintes de température par exemple aggravent la sensibilité aux faiblesses ou aux petits défauts internes.

Pour déterminer les faiblesses des circuits intégrés, il est connu de soumettre ceux-ci à un rayonnement laser local et d'évaluer le fonctionnement du circuit sous une telle contrainte.

En particulier, il est connu d'exciter le circuit avec un signal d'entrée alors que celui-ci est soumis à un rayonnement laser et de vérifier que le résultat obtenu en sortie du circuit est correct. Le laser est appliqué sur une zone réduite du circuit intégré et le test est répété pour plusieurs positions du laser sur la surface du circuit, de manière à balayer l'ensemble du circuit et ainsi créer une cartographie du circuit permettant de repérer les zones qui, lorsqu'elles sont soumises à un rayonnement laser, conduisent à ce que le circuit produise en sortie un résultat non conforme.

Un tel procédé est décrit, par exemple, dans le document US 6,483,322 et le document US-4,698,587.

Ces procédés d'analyse sont relativement efficaces mais ne permettent que la détection de défauts significatifs dans le circuit qui, lorsqu'ils sont soumis à un rayonnement laser, conduit à un dysfonctionnement visible du circuit, en ce sens qu'il ne fournit pas le résultat escompté.

En revanche, un tel procédé n'est pas en mesure de localiser des défauts minimes qui pourtant peuvent s'avérer préjudiciables lors de l'utilisation répétée du circuit dans un environnement particulièrement contraint.

US-6,501,288 décrit un procédé mesurant le temps de propagation dans le circuit suite à une simple soumission à un rayonnement laser.

L'invention a pour but de proposer un procédé d'analyse et une installation d'analyse d'un circuit permettant de déterminer de tels défauts minimes ou zones sensibles.

A cet effet, l'invention a pour objet un procédé d'analyse d'un circuit intégré, caractérisé en ce qu'il comporte pour une pluralité de points à la surface du circuit intégré :
- une étape d'application d'un rayonnement laser, en un point de la surface du circuit intégré :
- une étape d'excitation du circuit ;
- une étape de recueil de la réponse du circuit à l'excitation ;
- une étape de calcul du temps de propagation séparant l'instant d'excitation du circuit de l'instant de recueil de la réponse ; et
- une étape de création d'une image du circuit intégré illustrant une valeur représentative du temps de propagation pour chaque point d'application du rayonnement laser.

Suivant des modes particuliers de mise en oeuvre, le procédé d'analyse comporte l'une ou plusieurs des caractéristiques suivantes :
- une étape d'excitation du circuit en l'absence de rayonnement laser;
- une étape de recueil de la réponse du circuit à l'excitation ;
- une étape de calcul du temps de propagation en l'absence de rayonnement laser séparant l'instant d'excitation du circuit de l'instant de recueil de la réponse ;
- ladite valeur représentative du temps de propagation est égale à la variation du temps de propagation définie par la différence entre le temps de propagation en présence du rayonnement laser en un point déterminé et le temps de propagation en l'absence de rayonnement laser ;
- le rayonnement laser a une longueur d'onde comprise entre 800 nm et 1400 nm ;
- la longueur d'onde du rayonnement laser est choisie dans le groupe consistant en 1064 nm et 1340 nm ;
- le rayonnement laser est appliqué en chaque point de manière synchrone avec l'étape d'excitation du circuit ;
- le rayonnement laser est appliqué en chaque point de manière asynchrone avec l'étape d'excitation du circuit ;
- le rayonnement laser est pulsé avec au moins une impulsion en chaque point du circuit ;
- le rayonnement laser est modulé avec au moins une impulsion en chaque point du circuit ; et
- le rayonnement laser est continu.

L'invention a également pour objet une installation d'analyse d'un circuit intégré, caractérisé en ce qu'il comporte :
- des moyens pour appliquer un rayonnement laser successivement en une pluralité de points à la surface du circuit intégré ;
- des moyens pour exciter le circuit pour chaque application du rayonnement laser en un point ;
- des moyens pour recueillir la réponse du circuit à l'excitation ;
- des moyens pour calculer, pour chaque point, le temps de propagation séparant l'instant d'excitation du circuit de l'instant de recueil de la réponse ; et
- des moyens pour créer une image du circuit intégré illustrant une valeur représentative du temps de propagation pour chaque point d'application du rayonnement laser.

L'invention sera mieux comprise à la lecture de la description qui va suivre, donnée uniquement à titre d'exemple, et faite en se référant aux dessins, sur lesquels :
- la figure 1 est une vue schématique d'une installation d'analyse d'un circuit mettant en oeuvre un procédé selon l'invention ;
- la figure 2 est un organigramme de l'algorithme mis en oeuvre par l'installation de la figure 1 ; et
- la figure 3 est un exemple d'image d'un circuit obtenue par mise en oeuvre du procédé selon l'invention.

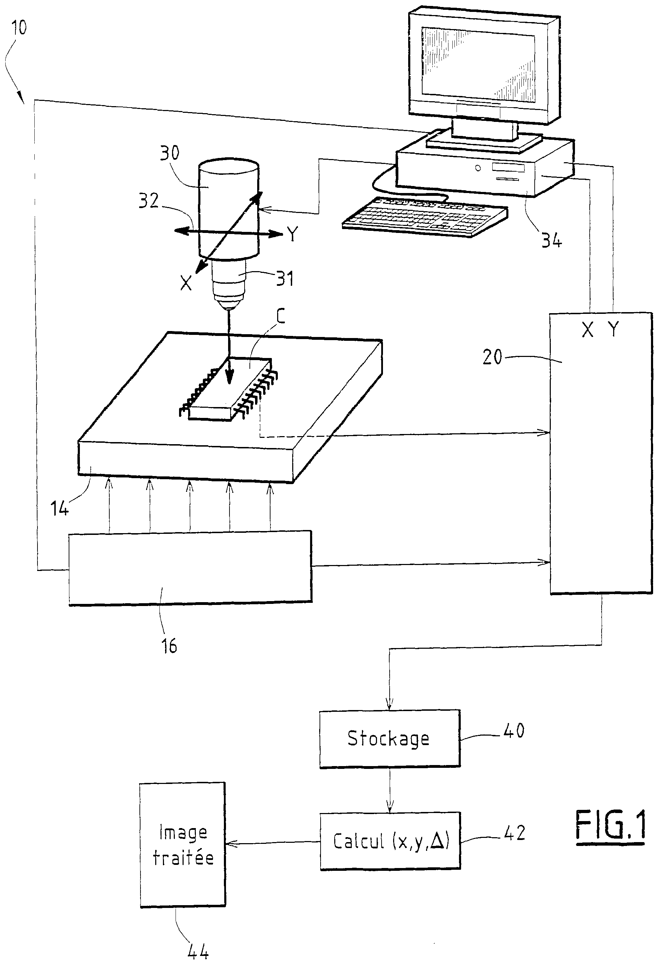

L'installation illustrée sur la figure 1 comporte une installation 10 d'analyse d'un circuit intégré C comportant une platine 14 de réception et de connexion du circuit intégré et un générateur 16 d'une séquence de test dont les sorties sont reliées aux entrées du circuit intégré au travers de la platine 14. Au moins une sortie du circuit intégré est reliée à une unité de mesure temporelle 20.

Le générateur de séquence de test 16 est relié à une entrée de l'unité 20 de mesure temporelle afin de recevoir une impulsion lors de l'instant d'excitation du circuit par envoi à celui-ci d'une séquence de test prédéterminé. L'unité de mesure temporelle 20 reçoit la réponse du circuit à l'instant où celle-ci ressort du circuit après que les informations se soient propagées à l'intérieur du circuit.

Par ailleurs, l'installation 10 comporte une source laser 30 disposée au droit du circuit à tester et sur lequel un objectif 31 est monté. La source laser 30 est portée par des moyens 32 de déplacement du faisceau laser dans le plan du circuit suivant deux directions perpendiculaires l'une à l'autre.

Les moyens de déplacement 32 sont reliés à une unité de pilotage 34 propre à commander la position du laser et à commander le déclenchement de celui-ci.

L'unité de pilotage 34 est formée par exemple d'un ordinateur associé à des moyens de commande.

En outre, l'unité de pilotage 34 est reliée à l'unité de génération de séquences de test 16 pour déclencher l'excitation du circuit de manière synchronisée avec l'illumination locale du circuit depuis le laser 30.

Suivant un mode de réalisation, le faisceau laser a une longueur d'onde supérieure à 1100 nm et de préférence égale à 1340 nm et est propre à induire un effet thermique dans le matériau semi-conducteur propre à modifier sa résistivité locale.

Suivant un autre mode de réalisation, le faisceau laser a une longueur d'onde inférieure à 1100 nm, de préférence comprise entre 800 nm et 1100 nm et est propre à induire des phénomènes photoélectriques dans le matériau du circuit.

Par ailleurs, le laser a une longueur d'onde comprise entre 1000 nm et 1400 nm lorsqu'il traverse une couche de silicium. La transparence du silicium à ces longueurs d'ondes permet de réaliser des analyses au travers du substrat, sans être écranté par les couches métalliques distribuées sur la surface du circuit.

En particulier, lorsque des phénomènes photoélectriques sont mis en évidence et que le laser traverse une couche de silicium, le laser présente de préférence une longueur d'onde de 1064 nm, de manière à permettre que le rayonnement laser induise la création de paires électrons-trous dans le semi-conducteur formant le circuit, ces paires électrons-trous donnant naissance à la circulation d'un courant.

Le faisceau laser présente une distribution gaussienne, lorsqu'il a atteint sa limite de résolution.

L'unité de pilotage 34 est reliée à l'unité de mesure temporelle 20 pour fournir les coordonnées X et Y du faisceau laser dans le plan du circuit, ces coordonnées étant représentatives de la position du point d'impact du faisceau laser sur le circuit.

Par ailleurs, l'installation comporte une unité 40 de stockage en temps réel propre à mémoriser, lors de chaque test effectué sur le circuit, les positions X, Y du point d'impact du faisceau laser, ainsi que l'instant t1 d'excitation du circuit et l'instant t2 du recueil d'une réponse en sortie du circuit. Ces moyens de stockage sont propres à recevoir ces informations à un rythme très élevé lorsqu'elles sont déterminées par l'unité 20.

Les moyens de stockage 40 sont reliés à des moyens de calcul 42 propres à déterminer, pour chaque point d'impact du faisceau laser défini par des coordonnées X, Y, une valeur représentative du temps de propagation t du signal dans le circuit. Cette valeur est par exemple la variation entre le temps de propagation t en présence du rayonnement laser et le temps de propagation t_{R} en l'absence du rayonnement laser, appelé ultérieurement temps de propagation de référence. Cette variation est définie par Δ = t - t_{R} = t2 - t1 - (t02 - t01) où t1 et t2 sont les instants d'excitation et de recueil en présence de faisceau laser et t01 et t02 sont les instants d'excitation et de recueil en l'absence de faisceau laser pour la même séquence de test.

Les moyens de calcul 42 sont propres à déterminer les triplets (X, Y,Δ) pour tous les points du circuit. Ils sont reliés en sortie à des moyens de création 44 d'une image du circuit, cette image représentant les valeurs de la variation Δ du temps de propagation résultant de la présence du faisceau laser suivant toute la surface du circuit.

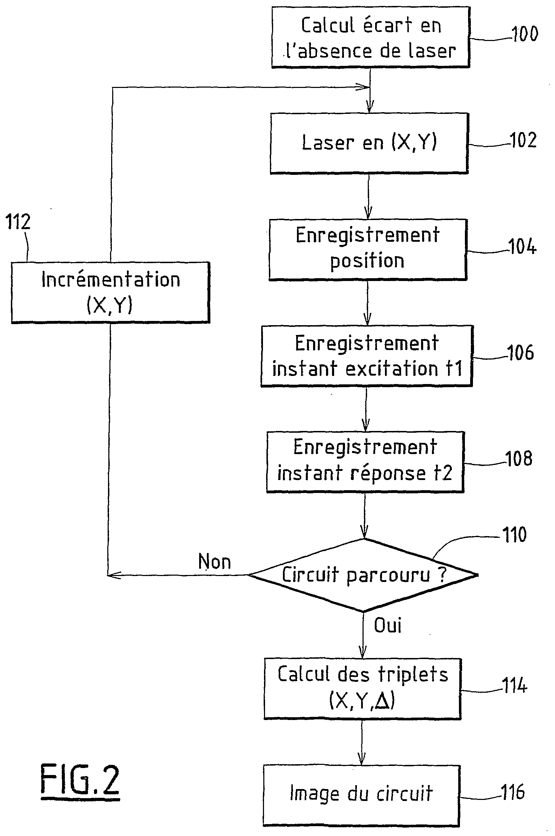

L'installation de la figure 1 est propre à mettre en oeuvre l'algorithme illustré sur la figure 2.

Initialement, à l'étape 100, aucun rayonnement laser n'est appliqué sur le circuit. Une mesure du temps de propagation de référence t_{R} en l'absence de rayonnement laser est effectuée en un unique point du circuit. A cet effet, le circuit est excité à partir d'une séquence de test. L'instant d'excitation t01 du circuit et l'instant t02 de recueil de la réponse sont déterminés par l'unité de mesure temporelle. Ces valeurs sont stockées dans les moyens de stockage 40.

A l'étape 102, le laser est commandé pour illuminer une région réduite du circuit de coordonnées X, Y. A l'étape 104, ces coordonnées sont enregistrées dans les moyens de stockage 40. Le circuit ainsi illuminé ou préalablement illuminé par le faisceau laser est excité à l'étape 106 par l'envoi d'une séquence de test, et l'instant t1 d'excitation est enregistré. L'instant t2 d'obtention de la réponse par l'unité 20 est enregistré à l'étape 108 dans les moyens de stockage 40.

Selon un premier mode de réalisation de l'invention, le faisceau laser est continu.

Pour les étapes 102 à 108, suivant ce premier mode de réalisation, le rayonnement laser est appliqué sur une région réduite du circuit de manière simultané avec l'application de la séquence de test, de sorte que le circuit est illuminé au cours de la séquence de test.

Suivant un second mode de réalisation de l'invention, au contraire, le faisceau laser est pulsé avec des durées d'impulsions préférablement inférieures à la nanoseconde ou le faisceau laser est modulé avec des durées d'impulsions préférablement inférieures ou égales à la durée de la séquence de test appliquée au circuit. Le circuit est alors illuminé pendant des durées prédéterminées de la séquence de test.

Suivant le second mode de réalisation, la séquence de test est préférentiellement répétée plusieurs fois pour mesurer la variation du temps de propagation pour plusieurs moments différents de la séquence de test.

Suivant le second mode de réalisation, le faisceau laser est appliqué pendant une durée totale prédéterminée et suivant une zone réduite du circuit, soit de manière synchrone, soit de manière asynchrone avec l'application de la séquence de test.

Lorsque les applications sont dites synchrones, l'application du laser commence et se termine à des moments fixes et prédéterminés par rapport au début et à la fin de la séquence de test.

Lorsque les applications sont dites asynchrones, l'application du faisceau laser commence et se termine à des moments variables et aléatoires par rapport au début et à la fin des séquences de test.

Au cours des premier et le second modes de réalisation, les étapes 102 à 108 sont répétées successivement pour différentes positions du point d'impact du faisceau laser suivant le circuit, de sorte que le laser balaie l'ensemble du circuit. A cet effet, à l'étape 110, il est vérifié si l'ensemble du circuit a été parcouru. Si tel n'est pas le cas, le laser est déplacé à l'étape 112 par les moyens 32, de sorte que le point d'impact soit légèrement déplacé puis les étapes 102 à 108 sont à nouveau mises en oeuvre. L'étape 112 est conduite de sorte que, par mise en oeuvre de la boucle, l'ensemble de la surface du circuit soit progressivement parcouru.

A l'issue du balayage complet du circuit, les instants d'excitation t1 et de réponse t2, pour chaque position de coordonnées X, Y sont mémorisés dans les moyens de stockage 40.

A l'étape 114, un traitement des données ainsi stockées est effectué. En particulier, un temps de propagation de référence t_{R} est calculé à partir des instants d'excitation t01 et de réponse t02 obtenus, lorsque le circuit fonctionne en l'absence de sollicitation par un faisceau laser. Le temps de propagation t est calculé à partir des instants d'excitation t1 et de recueil t2 de la réponse obtenus en présence du faisceau laser pour chaque position d'application du faisceau laser de coordonnées X, Y.

Ensuite, à l'étape 114, tous les triplets (X, Y, Δ) sont calculés pour chacun des points X, Y d'impact du faisceau laser, Δ étant la variation temporelle de propagation entre le temps de propagation de référence t_{R} et le temps de propagation t calculé pour chaque position du faisceau laser de coordonnées X, Y.

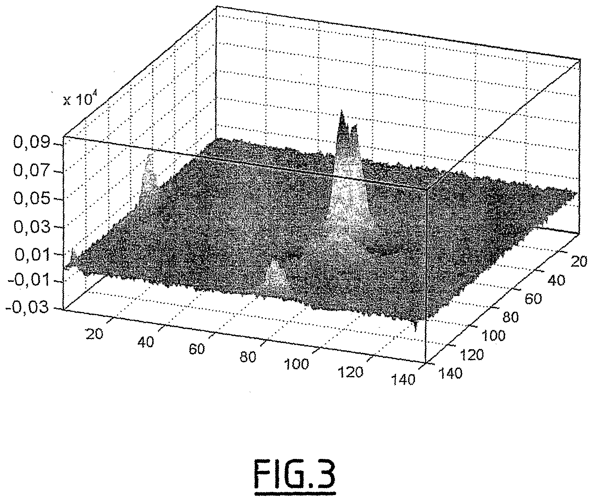

A l'étape 116, une image du circuit est produite par le dispositif de création d'image 44. Une telle image est illustrée sur la figure 3. Sur cette image, est illustrée la variation du retard temporelle de propagation calculée à l'étape 114 pour chacune des positions de coordonnées X, Y de sollicitation du faisceau laser.

Pour faciliter la visualisation des zones de défaut ou de faiblesse du circuit, une image en deux dimensions selon les axes X et Y, est extraite de l'image illustrée sur la figure 3. Sur cette image en deux dimensions, les variations du temps de propagation Δ sont colorisées selon différentes couleurs.

Cette image en deux dimensions est superposée à l'image optique du circuit référencé par les coordonnées X, Y. Cette image optique est obtenue à l'aide du laser 30 ou d'une caméra optique CCD.

La présence du faisceau laser en un point produit une variation du temps de propagation. Celle-ci est particulièrement significative pour certaines zones du circuit. Cette variation peut être positive ou négative en fonction de l'effet du faisceau laser, de sorte que, pour certaines zones, la réponse est obtenue plus rapidement en présence du faisceau laser alors que, pour d'autres, la réponse est retardée. Dans certains cas, la variation va conduire à la propagation d'une information erronée dans le circuit. La réponse erronée du circuit sera elle aussi plus ou moins retardée ou avancée. Avantageusement la variation temporelle d'une réponse erronée pourra être observée sur une autre sortie du circuit.

Les zones où la variation temporelle est importante apparaissent clairement sur l'image de la figure 3 et correspondent a priori à des régions du circuit qui comportent des défauts qui sont certes mineurs puisqu'ils ne sont pas de nature à faire que le circuit produise un résultat erroné mais qui peuvent s'avérer préjudiciables pour le circuit en cas de fonctionnement dans un environnement très contraint.

Selon un mode de réalisation de l'invention, la valeur représentative du temps de propagation t est égale à la variation de temps entre l'instant d'excitation t1 et l'instant de recueil t2 (t = t2 - t1), lorsque le faisceau laser est ou a été appliqué sur le circuit C. Dans ce cas, il n'est pas tenu compte du temps de propagation de référence t_{R} qui représente une valeur moyenne non représentative des défauts ou des zones sensibles du circuit.

## Revendications

1. Procédé d'analyse d'un circuit intégré (C), **caractérisé en ce qu'**il comporte, pour une pluralité de points (X, Y) à la surface du circuit intégré (C) :
- une étape d'application (102) d'un rayonnement laser, en un point (X, Y) de la surface du circuit intégré (C) :
- une étape (106) d'excitation du circuit (C) par une séquence de test ;
- une étape (108) de recueil de la réponse du circuit (C) à l'excitation ;
- une étape (114) de calcul du temps de propagation (t) séparant l'instant (t1) d'excitation du circuit (C) de l'instant (t2) de recueil de la réponse ; et
- une étape (116) de création d'une image du circuit (C) intégré illustrant une valeur représentative du temps de propagation (t) pour chaque point d'application (X, Y) du rayonnement laser.

2. Procédé selon la revendication 1, **caractérisé en ce qu'**il comporte :
- une étape (100) d'excitation du circuit (C) en l'absence de rayonnement laser;
- une étape (100) de recueil de la réponse du circuit (C) à l'excitation ;
- une étape (114) de calcul du temps de propagation (t_{R}) en l'absence de rayonnement laser séparant l'instant d'excitation (t01) du circuit de l'instant de recueil (t02) de la réponse ; et
**en ce que** ladite valeur représentative du temps de propagation (t) est égale à la variation du temps de propagation (Δ) définie par la différence entre le temps de propagation (t) en présence du rayonnement laser en un point déterminé et le temps de propagation (t_{R}) en l'absence de rayonnement laser.

3. Procédé selon la revendication 1 ou 2, **caractérisé en ce que** le rayonnement laser a une longueur d'onde comprise entre 800 nm et 1400 nm.

4. Procédé selon la revendication 3, **caractérisé en ce que** la longueur d'onde du rayonnement laser est choisie dans le groupe consistant en 1064 nm et 1340 nm.

5. Procédé selon l'une quelconque des revendications précédentes, **caractérisé en ce que** le rayonnement laser est appliqué en chaque point (X, Y) de manière synchrone avec l'étape (106) d'excitation du circuit.

6. Procédé selon l'une quelconque des revendications 1 à 4, **caractérisé en ce que** le rayonnement laser est appliqué en chaque point (X, Y) de manière asynchrone avec l'étape (106) d'excitation du circuit.

7. Procédé selon l'une quelconque des revendications précédente, **caractérisé en ce que** le rayonnement laser est puisé avec au moins une impulsion en chaque point (X, Y) du circuit.

8. Procédé selon l'une quelconque des revendications 1-7, **caractérisé en ce que** le rayonnement laser est modulé avec au moins une impulsion en chaque point (X, Y) du circuit.

9. Procédé selon l'une quelconque des revendications 1-7, **caractérisé en ce que** le rayonnement laser est continu.

10. Installation d'analyse (10) d'un circuit intégré (C), **caractérisé en ce qu'**il comporte :
- des moyens (30, 31) pour appliquer un rayonnement laser successivement en une pluralité de points (X, Y) à la surface du circuit intégré (C) ;
- des moyens (16, 34) pour exciter le circuit (C) avec une séquence de test pour chaque application du rayonnement laser en un point (X, Y);
- des moyens (20, 34) pour recueillir la réponse du circuit (C) à l'excitation ;
- des moyens (42) pour calculer, pour chaque point (X, Y), le temps de propagation (t) séparant l'instant d'excitation (t1) du circuit de l'instant de recueil (t2) de la réponse ; et
- des moyens (44) pour créer une image du circuit intégré illustrant une valeur représentative du temps de propagation (t) pour chaque point d'application (X, Y) du rayonnement laser.

## Patentansprüche

1. Verfahren zur Analyse einer integrierten Schaltung (C), **dadurch gekennzeichnet, dass** es für mehrere Punkte (X, Y) auf der Fläche der integrierten Schaltung (C) umfasst:
- einen Schritt zum Anlegen (102) einer Laserstrahlung an einen Punkt (X, Y) der Fläche der integrierten Schaltung (C);
- einen Schritt (106) zum Anregen der Schaltung (C) durch eine Prüfsequenz;
- einen Schritt (108) zum Erfassen der Antwort der Schaltung (C) auf die Anregung;
- einen Schritt (114) zum Berechnen der Ausbreitungszeit (t), die den Moment (t1) der Anregung der Schaltung (C) vom Moment (t2) der Erfassung der Antwort trennt; und
- einen Schritt (116) zum Erstellen einer Abbildung der integrierten Schaltung (C), die einen repräsentativen Wert der Ausbreitungszeit (t) für jeden Anlegepunkt (X, Y) der Laserstrahlung darstellt.

2. Verfahren nach Anspruch 1, **dadurch gekennzeichnet, dass** es umfasst:
- einen Schritt (100) zum Anregen der Schaltung (C) bei Abwesenheit von Laserstrahlung;
- einen Schritt (100) zum Erfassen der Antwort der Schaltung (C) auf die Anregung;
- einen Schritt (114) zum Berechnen der Ausbreitungszeit (t_{R}) bei Abwesenheit von Laserstrahlung, die den Anregungsmoment (t01) der Schaltung (C) vom Erfassungsmoment (t02) der Antwort trennt; und
dass der repräsentative Wert der Ausbreitungszeit (t) gleich der Veränderung der Ausbreitungszeit (Δ) ist, die durch die Differenz zwischen der Ausbreitungszeit (t) im Beisein der Laserstrahlung an einem vorbestimmten Punkt und der Ausbreitungszeit (t_{R}) bei Abwesenheit von Laserstrahlung definiert ist.

3. Verfahren nach Anspruch 1 oder 2, **dadurch gekennzeichnet, dass** die Laserstrahlung eine Wellenlänge zwischen 800 nm und 1400 nm hat.

4. Verfahren nach Anspruch 3, **dadurch gekennzeichnet, dass** die Wellenlänge der Laserstrahlung aus der Gruppe ausgewählt ist, die aus 1064 nm und 1340 nm besteht.

5. Verfahren nach einem der vorhergehenden Ansprüche, **dadurch gekennzeichnet, dass** die Laserstrahlung an jeden Punkt (X, Y) synchron mit dem Schritt (106) zum Anregen der Schaltung angelegt wird.

6. Verfahren nach einem der Ansprüche 1 bis 4, **dadurch gekennzeichnet, dass** die Laserstrahlung an jeden Punkt (X, Y) asynchron mit dem Schritt (106) zum Anregen der Schaltung angelegt wird.

7. Verfahren nach einem der vorhergehenden Ansprüche, **dadurch gekennzeichnet, dass** die Laserstrahlung mit mindestens einem Impuls an jedem Punkt (X, Y) der Schaltung gepulst ist.

8. Verfahren nach einem der Ansprüche 1 bis 7, **dadurch gekennzeichnet, dass** die Laserstrahlung mit mindestens einem Impuls an jedem Punkt (X, Y) der Schaltung moduliert ist.

9. Verfahren nach einem der Ansprüche 1 bis 7, **dadurch gekennzeichnet, dass** die Laserstrahlung kontinuierlich ist.

10. Analyseeinrichtung (10) für eine integrierte Schaltung (C), **dadurch gekennzeichnet, dass** sie umfasst:
- Mittel (30, 31), um eine Laserstrahlung sukzessive an mehrere Punkte (X, Y) auf der Fläche der integrierten Schaltung (C) anzulegen;
- Mittel (16, 34), um die Schaltung (C) mit einer Prüfsequenz für jedes Anlegen der Laserstrahlung an einen Punkt (X, Y) anzuregen;
- Mittel (20, 34), um die Antwort der Schaltung (C) auf die Anregung zu erfassen;
- Mittel (42), um für jeden Punkt (X, Y) die Ausbreitungszeit (t) zu berechnen, die den Anregungsmoment (t1) der Schaltung vom Erfassungsmoment (t2) der Antwort trennt; und
- Mittel (44), um eine Abbildung der integrierten Schaltung zu erstellen, die einen repräsentativen Wert der Ausbreitungszeit (t) für jeden Anlegepunkt (X, Y) der Laserstrahlung darstellt.

## Claims

1. A method for analyzing an integrated circuit (C), **characterized in that** it comprises, for a plurality of points (X, Y) on the surface of the integrated circuit (C):
- a step (102) for applying laser radiation at a point (X, Y) of the surface of the integrated circuit (C);
- a step (106) for exciting the circuit (C) by a test sequence;
- a step (108) for collecting the response of the circuit (C) to the excitation;
- a step (114) for calculating the propagation time (t) separating the instant (t1) of excitation of the circuit (C) from the instant (t2) of collection of the response; and
- a step (116) for creating an image of the integrated circuit (C) illustrating a value representing the propagation time (t) for each point of application (X, Y) of the laser radiation.

2. A method according to claim 1, **characterized in that** it comprises:
- a step (100) for exciting the circuit (C) in the absence of laser radiation;
- a step (100) for collecting the response of the circuit (C) to the excitation;
- a step (114) for calculating the propagation time (t_{R}) in the absence of laser radiation separating the instant of excitation (t01) of the circuit from the instant of collection (t02) of the response; and
**in that** the value representing the propagation time (t) is equal to the variation in propagation time (Δ), this variation being defined by the difference between the propagation time (t) in the presence of laser radiation at a determined point and the propagation time (t_{R}) in the absence of laser radiation.

3. A method according to either claim 1 or claim 2, **characterized in that** the laser radiation has a wavelength of between 800 nm and 1400 nm.

4. A method according to claim 3, **characterized in that** the laser radiation wavelength is chosen to be in the group including 1064 nm and 1340 nm.

5. A method according to any one of the preceding claims, **characterized in that** the laser radiation is applied at each point (X, Y) in a manner that is synchronous with the step (106) for exciting the circuit.

6. A method according to any one of claims 1 to 4, **characterized in that** the laser radiation is applied at each point (X, Y) in a manner that is asynchronous with the step (106) for exciting the circuit.

7. A method according to any one of the preceding claims, **characterized in that** the laser radiation is pulsed with at least one pulse at each point (X, Y) of the circuit.

8. A method according to any one of claims 1 to 7, **characterized in that** the laser radiation is modulated with at least one pulse at each point (X, Y) of the circuit.

9. A method according to any one of claims 1 to 7, **characterized in that** the laser radiation is continuous.

10. An installation (10) for analyzing an integrated circuit (C), **characterized in that** it comprises:
- means (30, 31) for applying laser radiation successively at a plurality of points (X, Y) on the surface of the integrated circuit (C);
- means (16, 34) for exciting the circuit (C) with a test sequence for each application of the laser radiation at a point (X, Y);
- means (20, 34) for collecting the response of the circuit (C) to the excitation;
- means (42) for calculating, for each point (X, Y), the propagation time (t) separating the instant of excitation (t1) of the circuit from the instant of collection (t2) of the response; and
- means (44) for creating an image of the integrated circuit illustrating a value representing the propagation time (t) for each point of application (X, Y) of the laser radiation.
